# EUROPEAN PATENT APPLICATION

(11) **EP 1 066 932 A2**
(43) Date of publication of application: **10.01.2001**
(21) Application number: 99124250.4
(22) Date of filing: 04.12.1999
(51) Int. Cl.: B26D 7/18, B26F 1/02

(54) **Die structure**

(30) Priority: 30.06.1999 JP 18669899
(71) Applicant: UHT Corporation, Aichi-gun, Aichi-ken (JP)
(72) Inventor: Wakabayashi, Noriyuki, c/o UHT Corporation, Aichi-gun, Aichi-ken (JP); Kimura, Naoyuki, c/o UHT Corporation, Aichi-gun, Aichi-ken (JP)
(74) Representative: Denmark, James

(57) **Abstract**

There is provided a die structure having a simple configuration in which a damage of thin plate-like material (workpiece) caused by a continuous punching of holes while punctured chips are being adhered to the extremity end of the punch is prevented and the punctured chips are prevented from being raised as the punch is lifted up to close the punctured punch holes. The punch P pierces into the resilient film 3. The pierced hole of the resilient film 3 punched by the punch P is kept at a state in which it is extended instantly, torn out, removed and resiliently expanded, and in turn when the punch P is pulled out of it, it is resiliently shrunk into a smaller shape than that of the punch P. The punctured chip (c) adhered to the extremity end of the punch P is engaged with the resilient film 3 (more practically, an edge of the punctured hole to be shrunk) which is shrunk when the punch P is raised and then drops.

## Description

### BACKGROUND OF THE INVENTION

### 1. Field of the Invention

This invention relates to a die structure which is useful for punching operation for thin plate-like material such as a ceramic green sheet, a flexible substrate as well as a complex material tape and the like for TCP (Tape Carrier Package), T-BGA (Tape Ball Grid Array) and T-CSP (Tape Chip Size Package) by a TAB (Tape Automated Bonding), and a BGA (Ball Grind Array) and CSP (Chip Size Package) and the like by a flexible sheet etc.

### 2. Description of the Related Art

In a punching machine, when a thin plate-like material is punctured by a punch, the punctured chips of the thin plate-like material are press contacted with the extremity end surface of the punch and adhered to it. Then, if the punctured punching operation is continued while this state is being kept, the punctured chips adhered to the extremity end surface of the punch may damage the surface of the thin plate-like material, reduce a yield and remarkably reduce its value as a commodity.

In view of the foregoing, as the conventional means for solving this problem, there is proposed an invention in which a resilient member is arranged at the inner surface of the punched hole formed at the die, as disclosed in Japanese Patent Laid-Open No. Hei 10-156446, for example, and then the punctured chips are prevented from being lifted up as the punch is lifted up.

However, in the case that the thin plate-like material such as a flexible substrate or a ceramics green sheet and the like is punctured, a diameter of the hole to be punctured is a quite fine diameter of 50 to 100 µm and the punctured hole is also formed in such a quite fine diameter. Thus, an operation for arranging a resilient member at the inner side surface of the punctured hole of quite fine diameter is quite difficult. Further, in the case that a so-called gang-type device in which a punching unit installed on a punching machine concurrently applies many punctured holes, the aforesaid operation becomes quite hard due to the fact that one die is provided with many punctured holes.

In addition, as another solving means, as disclosed in Japanese Utility Model Laid-Open No. Sho 63-66518, there is provided a system in which a steel plate punch dust removing mechanism resiliently press contacted with the punch is arranged at the lower end of the puncture hole of the die fitted to the die holder through bushing, although means for fixing the punch dust removing mechanism to the rear surface of the die is a screw fixing or the like, so that its operation is troublesome and takes much time. Additionally, in the case that the punctured hole has a quite fine diameter, it is difficult for the puncture dust removing mechanism to be formed into an inverse nozzle and in turn in the case that the punching unit is a gang type in the same manner as that of the prior art system, this may provide a problem that both fixing flange portions to be fixed to the rear surface of the die may interfere with another adjoining puncture dust removing mechanism and making its fixing operation inoperative.

The present invention has been invented in view of the aforesaid circumstances in the prior art, and its object is to provide a die structure having a simple configuration in which a damage of a thin plate-like material (a workpiece) caused by a continuous punching while the punctured chips are being adhered to the extremity end of the punch is prevented.

It is another object of the present invention to provide a die structure in which the aforesaid object is accomplished in correspondence with a requirement of the punching industry to produce a high concentrated unit.

It is still further object of the present invention to provide a die structure in which a punctured chip removing method in correspondence with some characteristics of various kinds of thin plate-like material (a workpiece) such as low viscosity, high viscosity and adhering characteristic or the like.

As a technical means applied for solving the aforesaid objects, claim 1 of the present invention has, as its gist, that there is provided a resilient film covering the lower releasing portions of each of the punch punctured holes of a die.

The resilient film in this case is a film formed by epoxy, urethane and silicon or the like, for example.

Then, as means for arranging this resilient film to cover the lower releasing portion of the punch punctured hole, it may include a general coating means for coating or drying liquid-like resilient member or adhering a film-like formed resilient member, or a configuration in which a lid member with an upper opening part of a cylinder part being closed by the thin film is integrally formed with the resilient member, this lid member is directed upward with the thin film being applied in the resilient film and fitted to an indentation formed at the rear surface of the die, or a configuration in which the lid-like member is removably fitted in this configuration or the like.

In addition, covering and fitting of the punch punctured holes include, for example, not only each of the individual corresponding holes of the punch but also the case in which an entire rear surface of the die is covered, resulting in that all the lower releasing portions of the punch punctured holes are covered.

In accordance with the aforesaid technical means, as the punch is descended, at first it punctures the thin plate-like material and then passes in the punch punctured hole, and further passes through the resilient film and pierces while the punctured chips are being adhered to the extremity end of the punch. At this time, the punctured hole in the resilient film punched by the punch is pulled instantly, torn out and kept at its resilient expanded shape, wherein as the punch is pulled out of it, the punched hole is resiliently shrunk into a smaller shape than the shape of the punch.

The punctured chips adhered to the extremity end of the punch are engaged with the edge of the punctured hole shrunk when the punch is lifted and then drops.

Claim 2 shows, as its gist, an arrangement in which each of said punch punctured holes described in claim 1 is opened at a cylindrical bushing type die having a bottom section that a nozzle port for ejecting air toward extremity ends of punches while being communicated with an air supplying passage which can be changed over in ON or OFF, the die is held by a die holder and there is provided a resilient film covering the lower releasing portions of the punch punctured holes at an inner surface top portion higher than the nozzle port.

In this claim 2, there is provided a general state in which the die having a punch punctured hole and having a nozzle port for ejecting air is fitted into each of the set holes in the die holder having a set hole for a bushing type die and used.

In accordance with the aforesaid technical means, the same action as that described in claim 1 may be acted and it becomes possible to blow the air ejection as required against the punctured chips adhered to the punch.

Accordingly, it is possible to employ both a peeling-off puncture chip removing method (system A) under utilization of shrinkage of the resilient film in response to the characteristics of various kinds of thin plate-like materials (workpiece) such as low viscosity, high viscosity and adhering characteristic or the like and a punctured chip removing method (system B) in which the peeling-off operation and an injection pressure with air ejection are cooperated to each other.

As the thin plate-like material, there are provided various kinds of complex sheet materials by TAB in which a reinforcing tape of PET is laminated at the rear surface with adhesive agent and in such a case of applying the thin film material, there occurs an occasion that a complete removal of the punctured chips can not be carried out positively only with the system A in which the shrinkage of the resilient film is utilized. In such a case as above, the aforesaid system B is used.

The air supplying passage is formed in the die holder and the support base for supporting the die holder.

Claim 3 has, as its gist, an arrangement in which each of the punch punctured holes is opened directly closely near the plate-like die in place of one using a bushing type die.

The plate-like die having the punch punctured hole is used in the gang type.

In accordance with this technical means, the same action as that of claim 1 can be attained in response to a requirement of punch punctured holes in which a high concentrated trend of nowadays is applied.

Claim 4 has, as its gist, an arrangement in which the air supplying passage that can be changed over in ON or OFF is formed at a support base for supporting a plate-like die.

In accordance with this technical means, it is possible to accomplish the same action as that described in claim 2 in reference to the same action as that of claim 3 described later.

Claim 5 has, as its gist, an arrangement in which in place of the bushing type die described in claim 2, a stripper bushing is replaced with it, fitted in the die holder in an inverse state and used, and there is provided the resilient film covering the lower releasing portions of the punch punctured holes at at least the inner surface top part of the stripper bushing.

This stripper bushing is constructed like a general bushing type die having a nozzle port opened, i.e. a simple structure having no bulged-out wall with the nozzle port being made thick at its wall, more practically, although its entire height is slightly lower than that of the bushing type die, its outer appearance has the same cylindrical shape with a bottom section, wherein the bottom wall and the peripheral wall are formed into a simple configuration in which no protrusion is formed at the inner part where they are cooperatively arranged at the inner surface side through an arcuate corner section. A punch insertion hole is opened at the center of the bottom wall.

This technical means is set such that the stripper bushing is applied as a die in its inverse state in reference to a characteristic of shape of a simple inner space described above and the punch insertion hole is utilized as the punch punctured hole.

If the stripper bushing is used as the die, no presence of bulged-out wall causes the work for the resilient film to be easily carried out when the liquid resilient member is coated, when the film-like formed resilient member is adhered and when it is removably fitted.

Claim 6 has, as its gist, an arrangement in which the resilient film arranged at the stripper bushing described in claim 5 is of a hat-shape in which a cylindrical resilient portion with a bottom section fitted along the inner surface of the stripper bushing and an annular spacer cooperatively arranged at the lower end of the resilient portion and held by the stripper bushing and the support base for a die holder are provided integrally or separately.

In accordance with this technical means, when the resilient film is of a fitted type, a difference in height between the bushing type die and the general die is accommodated by an annular spacer held between the stripper bushing and the support base for the die holder and the annular spacer is held to prevent the resilient film from being dropped.

Claim 7 has, as its gist, an arrangement in which a resilient film described in any one of claims 2, 3 and 5 has, at positions corresponding to its punches, narrower slits than a shape of the punch or smaller through-pass holes than a shape of the punch.

In this case, the slit includes a split having a specified slit and a recess or the like and the through-pass hole includes a hole corresponding to a shape of the punch such as a circular shape, a triangular shape and a square shape or the like.

In accordance with the aforesaid technical means, the extremity end of the punch adhered with the punctured chips passes through either the pre-arranged slit or through-pass hole. Accordingly, a force of the resilient film pushed and peeled off by the descending punch is restricted low.

Then, the punctured chips adhered to the extremity end surface of the punch are engaged with the inner edge of the slit when the punch is lifted up due to the fact that the slit or the through-pass hole is narrower or smaller than that of the punch shape and then the punctured chips are dropped.

Claim 8 shows, as its gist, an arrangement in which the slit and through-pass hole described in claim 7 are opened through melting with a heating pin inserted into and passed through the punch punctured hole after the resilient film is arranged to cover the lower releasing portion of the punch punctured hole.

In accordance with this technical means, it is possible to form either the slit or the through-pass hole under a high precision and to form the slit or the through-pass hole at the coating type resilient film afterward without making any precise position alignment of the resilient film having the slit or through-pass hole pre-formed in advance against the predetermined position as found in the fitted and adhering type.

Claim 9 shows, as its gist, an arrangement in which the resilient film arranged at the stripper bushing described in claim 5 is comprised of a flat plate-like resilient thin film opposing against the inner surface top part of the stripper bushing and a non-resilient cylindrical spacer fitted to hold the resilient thin film with the inner surface top part of the stripper bushing in place of a resilient film entirely formed of resilient member, the cylindrical spacer has integrally a fixed flange held and supported at its lower end by a stripper bushing and the support base for the die holder.

The resilient thin film defined in this case may be of a single plate or a laminated film material. The non-resilient cylindrical spacer defined in this case is made of metal and plastic material and further it may include a hard rubber showing a quite less resilient deformation.

This technical means enables the resilient thin film of a type in which it is abutted against the inner surface top part of the stripper bushing to be held at the cylindrical spacer in such a way that it may not be dropped and further only the resilient thin film can be replaced at the end of durable years.

### BRIEF DESCRIPTION OF THE DRAWINGS

Fig. 1 is a view for showing a state of use of a first preferred embodiment of the present invention, wherein (a) is a partial enlarged sectional view of it, and (b) is also a partial enlarged sectional view for showing a state in which a thin plate is being punched.

Fig. 2 is an enlarged sectional view for showing a state of use of a second preferred embodiment of the present invention.

Fig. 3 is an enlarged sectional view for showing a state of use of a third preferred embodiment of the present invention.

Fig. 4 is an enlarged sectional view for showing a state of use of a fourth preferred embodiment of the present invention, i.e. a state in which a through-pass hole is formed by a heating pin, wherein (a) indicates a state in which a heating pin is tried to be inserted into a resilient film, (b) indicates a state in which a through-pass hole is being formed, and (c) indicates a state in which a heating pin is lifted up.

Fig. 5 is an enlarged sectional view for showing a state of use of a fifth preferred embodiment of the present invention.

Fig. 6 is an enlarged sectional view for showing a state of use of a sixth preferred embodiment of the present invention, wherein (a) indicates a state before a thin plate is punched, and (b) indicates a punched state.

Fig. 7 is a front sectional view for showing a state of use of a seventh preferred embodiment of the present invention.

Fig. 8 is a perspective view for showing a die structure used in a seventh preferred embodiment of the present invention with a part being broken away.

### DESCRIPTION OF THE PREFERRED EMBODIMENTS

Referring now to the drawings, some preferred embodiments of the present invention will be described as follows.

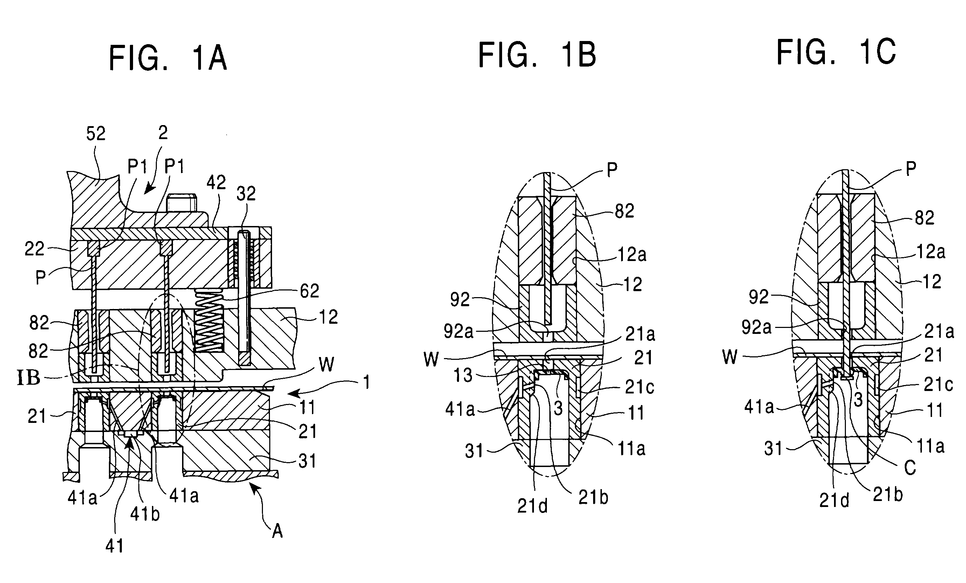

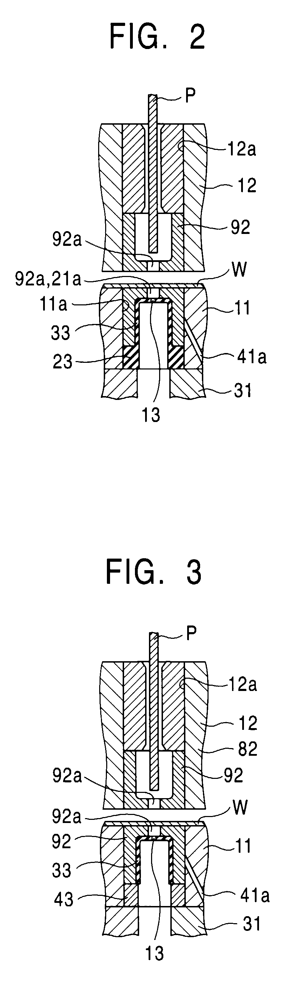

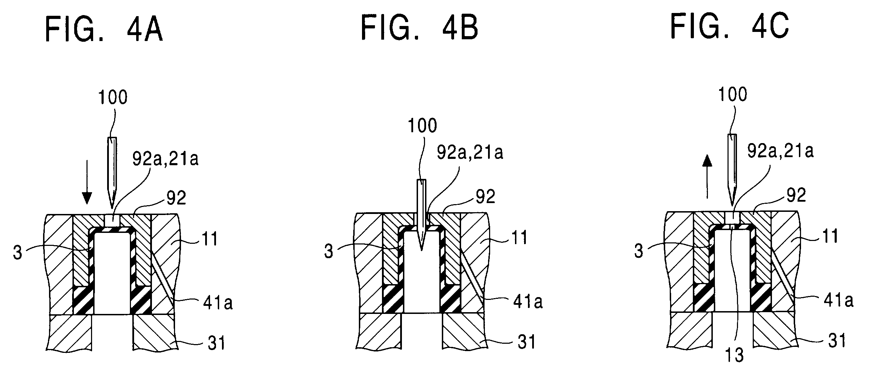

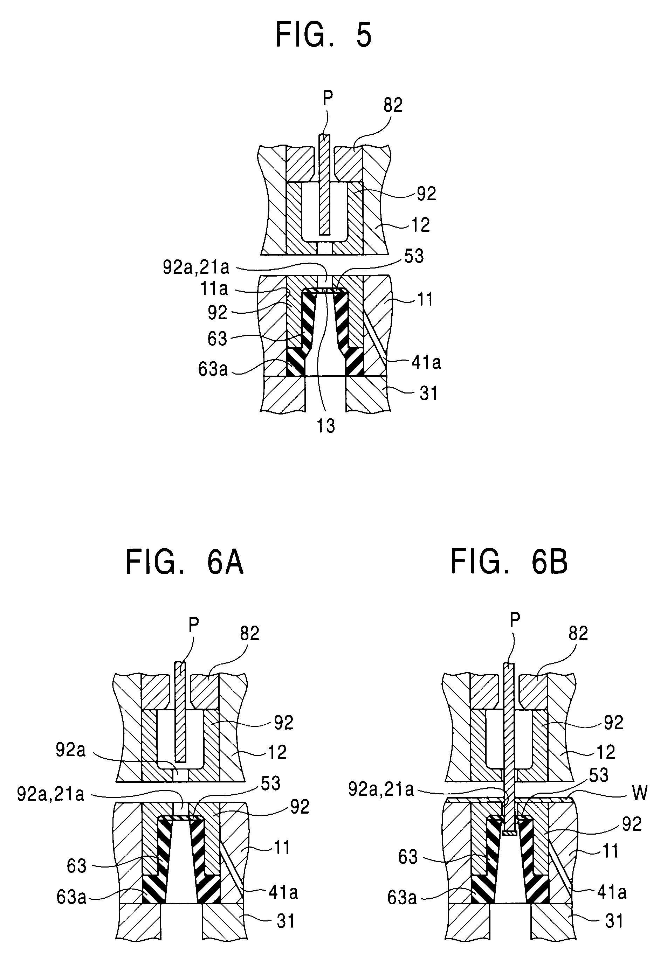

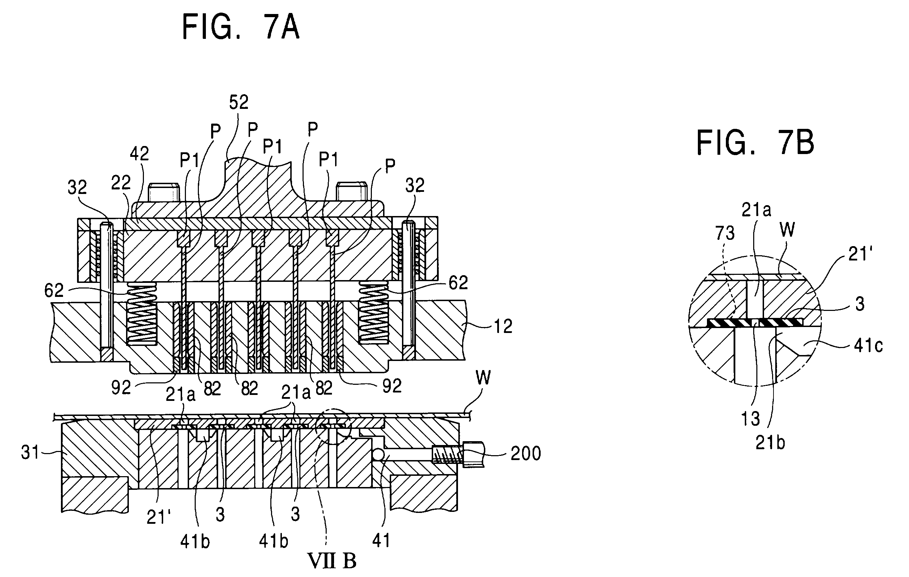

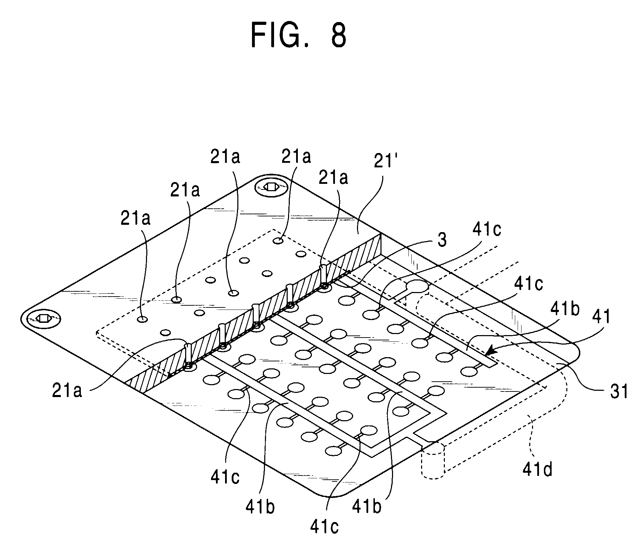

Fig. 1 indicates a first preferred embodiment of a die structure of the present invention, Fig. 2 indicates a second preferred embodiment of a die structure of the present invention, Fig. 3 indicates a third preferred embodiment of a die structure of the present invention, Fig. 4 indicates a fourth preferred embodiment of a die structure of the present invention, Fig. 5 indicates a fifth preferred embodiment of a die structure of the present invention, Fig. 6 indicates a sixth preferred embodiment of a die structure of the present invention, and Figs. 7 and 8 indicate a seventh preferred embodiment of a die structure of the present invention, respectively. Fig. 1 shows a substantial part of a punching machine, wherein its upper half segment indicates a punch holding die 2 and its lower half segment indicates a die structure 1 of the present invention.

The punch holding die 2 is comprised of a punch holder 12 fixedly arranged through a transporting space for a workpiece W between it and the uppermost die holder 11 of the die structure 1; a punch pat 22 arranged above the punch holder 12; a packing plate 42 holding a head part P1 of a punch P held by the punch pat 22 together with the punch pat 22 and having a punch ram 52 fixed on its upper surface; and a driving source (not shown) such as a servo-motor or the like communicated with the punch ram 52, wherein the punch pat 22 is guided by a guide post 32 against a punch holder 12 in such a way that it can be moved linearly, and a return spring 62 for returning the punch pat 22 every time a punching operation is performed is arranged between the punch holder 12 and the punch pat 22.

At the punch holder 12, each of a guide bushing 82 and a stripper bushing 92 is fitted to a set hole 12a punched in correspondence with each of the punches P in a vertical direction.

The stripper bushing 92 is made of super-hard alloy, wherein it shows a cylindrical shape having a bottom section with the same outer diameter as that of the bushing type die 21 fitted to the set hole 11a of the die holder 11 in such a way that it may be fitted or removed, although its height is set to be slightly low, no protrusion is present in the inner space of it, the bottom wall and the peripheral wall are set such that they are cooperatively communicated at the inner surface sides through an arcuate-shaped curved surface, and a punch insertion hole 92a is opened at the central part of the bottom wall.

The die structure 1 is comprised of a bushing type die 21, a die holder 11 for fitting and holding the die 21 and a support base 31 for supporting the die holder 11, wherein the support base 31 is removably thread fitted to a machine base A, the die holder 11 is removably thread fitted to the support base 31. The die holder 11 has the set hole 11a opened at a position opposing against the punch P held by the punch holding die 2 and the cylindrical die 21 with a bottom section of bushing type having a punch puncture hole 21a and an air ejecting nozzle port 21b for every set holes lla is removably fitted to the die holder and incorporated to it.

This die 21 is of a well-known form in which it has the same outer appearance as that of the stripper bushing 92 with the same diameter to each other, an indentation 21c is arranged at the midway part of the peripheral wall of the die, the die has, at its partial segment, a bulged-out wall 21d which is integrally projected into an inner space, and a slant upward directed nozzle port 21b with the extremity end of the bulged-out wall 21d being applied as an outlet is opened at the indentation 21c. A resilient film 3 is arranged at the upper side than the nozzle port 21b in such a way that it may cover a lower releasing segment of the punch puncture hole 21a.

This resilient film 3 is provided under an appropriate application of coating and adhesive agent or the like.

To the nozzle port 21b of this die 21 is communicated an air supplying passage 41 which can be changed over for its ON and OFF states.

This air supplying passage 41 is comprised of a communicating slant passage 41a opened into the die holder 11 to be communicated with the indentation 21c; an air guide groove 41b formed as an indentation at the upper surface of the support base 31 to which the lower end of one end of the communicating slant passage 41a by a precision machining operation such as an electrical discharge work or the like; and an air main passage (not shown) for communicating an air guide groove 41b not shown with a nipple (not shown; a nipple at the terminal end of a pneumatic circuit) connected to an outer end of the support base 31.

The resilient film 3 is formed with a smaller slit than a shape of the punch P or a smaller through-pass hole 13 than a shape of the punch P at a position corresponding to the punch P.

Although this slit or through-pass hole 13 may act as a guide section for the punch P, it may not dare to arrange the slit or through-pass hole and it may also be applicable that a guide hole similar to the slit or the through-pass hole is punched at the first by the punch P.

In the case of the die structure of this preferred embodiment, the air supplying passage 41 is turned ON or OFF in response to characteristics (low viscosity, high viscosity and adhering characteristic) of a thin plate material (workpiece) W. That is, in the case of low viscosity, the air supplying passage 41 is turned OFF (more practically, the air supplying source communicated with the air supplying passage is turned OFF), a puncture chip (c) adhered to the extremity of the punch P is peeled off only with the resilient film 3. In the case of a thin plate material having a high viscosity or adhering characteristic, the air supplying passage 41 is turned ON (more practically, the air supplying source communicated with the air supplying passage is turned ON), both a peeling action performed by an air ejection from the nozzle port 21b and a peeling-off action performed by the resilient film 3 are cooperatively carried out to remove the puncture chip (c) adhered to the extremity end of the punch P.

Then, referring now to Fig. 2, a second preferred embodiment of the present invention shown in this figure will be described as follows, wherein this preferred embodiment is operated such that a stripper bushing 92 is used in an inverse manner in place of the bushing type die 21 and removably fitted to the set hole lla and the punch insertion hole 92a is applied as the punch puncture hole 21a.

Since the bushing type die 21 has the bulged-out wall 21d having the nozzle port 21b opened therein as described above, if the resilient film 3 itself is of a fitting system having complex shape corresponding to it due to a special characteristic of its shape, its cost becomes high and it may become unsuitable during its use. Due to this fact, it is possible to say that it is preferable that the coating is applied in its adhesion state so as to cover the lower releasing part of the punch puncture hole 21a.

However, in the case of performing coating or adhesion, it becomes a troublesome operation for the resilient film 3 to be replaced with a new film at the time of end of durable state.

As described above, although the stripper bushing 92 has the same outer diameter as that of the bushing type die 21 and its length is set to be short, it has a cylindrical shape with the bottom section therein having no protrusion in it, resulting in that the resilient film 3 can be easily applied as a fitting system.

As shown in Fig. 2, the resilient film 3 has an integral assembly of an annular spacer 23 and a cylindrical resilient part 33 having a bottom section with a desired wall thickness extending along the inner surface of the stripper bushing 92 so as to fill a space between it and the upper surface of the support base 31. At the central part of the top section of the resilient part 33 is formed a slit narrower than a shape of the punch P or the through-pass hole 13 smaller than a shape of the punch P at the position corresponding to the punch P.

In the case of this preferred embodiment, it is of course apparent that the nozzle port 21b is not provided and it may be replaced with the die 21 having the nozzle port 21b and fitted through the set hole 11a, the annular spacer 23 is held by the lower end of the stripper bushing 92 and the upper surface of the support base 31 and held in such a way that it may not be dropped, the puncture chips adhered to the extremity end of the punch P are engaged with and peeled off under shrinkage of the resilient film 3, more practically shrinkage of the through-pass hole 13.

In addition, in the case of the third preferred second preferred embodiment, the resilient part 33 and the annular spacer 23 can be replaced together at the end of durable years and in the case of the third preferred embodiment, the cylindrical spacer 43 can be used in a continuous manner when it is replaced with a new one.

Next, referring to Fig. 4, a fourth preferred embodiment of the present invention will be described, wherein this preferred embodiment is operated such that the aforesaid slit or the through-pass hole 13 is formed from above, the resilient film 3 is melted by a heating pin 100 to be inserted into the punch puncture hole 21a after the film is arranged to cover the lower released part of the punch puncture hole 21a.

The extremity end of the heating pin 100 is made to have an acute headed shape.

In this figure is shown the resilient film 3 of the second preferred embodiment, although the present invention is not limited to this form, but the first and third preferred embodiments as well as the fifth preferred embodiment to be described later may form the slit or the through-pass hole 13 in the same manner as above.

Next, referring to Figs. 5 and 6, the fifth and sixth preferred embodiments of the present invention will be described, wherein the resilient film 3 arranged at the embodiment of the present invention shown in Fig. 3, the resilient film 3 is constituted by the cylindrical resilient part 33 having the bottom section and by a non-resilient cylindrical spacer 43 at its lower end.

As shown in Fig. 3, the resilient part 33 has a cylindrical shape with a bottom section of desired wall thickness extending along the inner surface of the stripper bushing 92 and then the resilient part 33 is fitted to the stripper bushing 92. Reference numeral 13 denotes a narrower slit than a shape of the punch P or a smaller through-pass hole than a shape of the punch at the position corresponding to the punch P.

The cylindrical spacer 43 is made of metal, plastic and hard rubber and the like and the cylindrical spacer 43 is present among the lower end of the stripper bushing 92, the lower end of the resilient part 33 and the upper surface of the support base 31 of the die holder 11 so as to hold the resilient part 33 in such a way that it may not be dropped.

Although the aforesaid preferred embodiments are of a fitting type, it is of course optional that the molded products are adhered, the coating for the resilient member is coated and dried to form a resilient part.

In the case that the fitting type is applied in this stripper bushing 92 is, in place of the entire resilient member, comprised of a flat plate-like resilient thin film 53 opposing against the inner surface top part of the stripper bushing 92 and a cylindrical spacer 63 fitted to hold the resilient thin film 53 with the inner surface top part of the bushing 92 while covering the lower releasing part of the punch puncture hole 21a.

The cylindrical spacer 63 has integrally a fixed flange 63a which is held by the stripper bushing 92 and the support base 31 for the die holder 11 at its lower end.

It is preferable that the cylindrical spacer 63 is formed by non-resilient member made of hard rubber, plastic and metal or the like.

The resilient thin film 53 in this preferred embodiment may be one of a single sheet plate as shown in Fig. 5 or a laminated member of films as shown in Fig. 6 and at the end of durable years, only the resilient film 53 can be replaced with a new one.

In the case of Fig. 5, either the narrower slit than a shape of the punch P or the smaller through-pass hole 13 than a shape of the punch P is applied. Fig. 6 shows a case in which a wall thickness is thin, so that either a narrower slit than a shape of the punch P or a smaller through-pass hole than a shape of the punch P is not applied, a punch hole is punctured in the resilient thin film 53 itself when the punch hole is punctured, and the punctured chips adhered at the punch due to the shrinkage of the punched hole when the punch is lifted up are engaged with and peeled off.

Then, referring to Figs. 7 and 8, the seventh preferred embodiment of the present invention will be described as follows. Some punch puncture holes 21a are punched closely near a plate-like die 21', lower side releasing sections of the punch puncture holes 21a are covered by the resilient film 3 and further the support base 31 is formed with an air supplying passage 41 which can be turned ON or OFF to eject air toward the extremity ends of the punches P projected from the resilient film 3.

In this preferred embodiment, the lower releasing portions of the punched puncture holes 21a are formed with indentations 73, and the resilient films 3 are installed in the indentations 73 by suitable means such as fitting or coating or adhering and the like.

As shown in Fig. 8, it is of course apparent that the resilient film 3 may be applied substantially over an entire rear surface of the plate-like die 21' so as to cover the lower releasing sections of all the punch punctured holes 21a.

Also in this preferred embodiment, the slits or through-pass holes 13 are opened.

The air supplying passage 41 is constituted such that air guide grooves 41b are indented at the surface of the support base 31 in parallel to each other by a precision machining such as an electrical discharge machining or the like between the punch punctured holes 21a, air communicating grooves 41c having, at their extremity ends, nozzle ports 21b for ejecting air toward the extremity ends of the punches P projected from the resilient film 3 while being communicated with the air guide grooves 41b, the air guide grooves 41b and a nipple 200 (nipple at the terminal end of a pneumatic circuit) at the outer end of the support base are communicated with an air main passage 41d opened into the support base 31, thereby it is possible to perform a peeling-off of the punctured chips adhered to the extremity ends of the punches P only with the resilient film 3 through turning ON or OFF of the air ejection or to perform a removal of the punctured chips adhered to the extremity ends of the punches P through cooperative action between a peeling-off with the air ejection from the nozzle ports 21b and a peeling-off with the resilient film 3.

The air guide grooves 41b, air communicating grooves 41c and nozzle ports 21b described above are closed at their upper releasing sections by the plate-like dies 21' so as to eject air from the nozzle ports 21b.

### EFFECTS OF THE INVENTION

Since the present invention has been constructed as described above, the present invention provides the following advantages.

In reference to Claim 1, since the resilient film is arranged to cover the lower releasing sections of each of the punch punctured holes of a die, the holes punctured in the resilient film by punches are torn out and removed after the resilient film is pulled out and extended instantly when the thin plate material is punctured and it is resiliently shrunk into a smaller shape than that of the punch when it is shrunk after the punches are pulled out of it.

Due to this fact, the punctured chips adhered to the extremity ends of the punches can be engaged with the hole edges of the punctured holes which are shrunk when the punch is lifted up.

Further, since it is satisfactory that the resilient film is arranged to cover the lower releasing sections of the punch punctured holes, the present invention does not show any problems at all as found in one prior art having the resilient member arranged at the inner peripheral surface of the punch punctured hole that, when a diameter of the hole punctured at a workpiece is quite fine, an operation for arranging the resilient member at the inner peripheral surface of the punch punctured hole having a corresponding fine diameter becomes quite hard; or problems in the other prior art having a punch punctured dust removing steel plate mechanism resiliently press contacted with the punch at the lower end of a bushing type die that the fixed flanges of the punctured dust removing mechanism are interfered to each other at the rear surface of the die and their fixing may become impossible, resulting in that the present invention may perform easily a fixing of the resilient film by appropriate means such as coating drying, adhering and fitting or the like.

In reference to Claim 2, since the resilient film is arranged to cover the lower releasing sections of each of the punch punctured holes at an inner surface top portion higher than a nozzle port in a bushing type die having the nozzle port for ejecting air, a system for peeling off the punctured chips under shrinkage of the punctured holes at the resilient film and a punctured chip removing system in which the peeling-off and an injection peeling-off with an air ejection can be separately used in compliance with characteristics (low viscosity, high viscosity and adhesion or the like) of the thin plate material to be punched.

In reference to Claim 3, in the case that the punch punctured holes are closely punctured near the plate-like die in place of applying the bushing type die and a resilient film is arranged to cover the lower releasing portions of the punch punctured holes, the chips of the thin plate-like material having quite short punching pitch adhered to the extremity ends of the punches can be removed through engagement under shrinkage of resilient film (shrinkage of punched holes) in the same manner as that described in Claim 1.

In reference to Claim 4, since an air supplying passage capable of changing-over for ON or OFF to eject air toward the extremity ends of the punches protruded from the resilient film covering the lower releasing portions of the punch punctured holes is communicated with the plate-like die, a system for peeling off the punctured chips of the thin plate-like material having quite short punching pitch through shrinkage of the resilient film (shrinkage of the punched holes) and a removing system having the peeling-off operation and an ejection peeling with air ejection are separately applied to enable the punctured chips adhered to the punches to be positively removed.

In reference to Claim 5, in the case that the stripper bushing is applied in its inverse state, this is a simple structure in which a bulged-out section having the thick walled nozzle port part is not provided as in a normal bushing type die having the opened nozzle port, so that this preferred embodiment has an effect that its installation work can be performed quite easily both for one case in which the resilient film is arranged through adhesion and the other case in which the resilient film is arranged through its fitting that can be replaced.

In reference to Claim 6, in the case that the resilient film arranged at the stripper bushing has a ha-shape having a cylindrical resilient part with a bottom section therein to be fitted along the inner surface of the stripper bushing and having an annular spacer cooperatively arranged at the lower end of the resilient part and held by the stripper bushing and the support base for the die holder, even if this is of a type in which the resilient film is fitted, a difference in height between the bushing type die and the stripper bushing is accommodated by the annular spacer present and held between the stripper bushing and the support base, and then the resilient film can be stably arranged in such a way that it may not be dropped by holding the annular spacer and further a replacement of the resilient film is carried out quite easily as compared with adhering and coating or the like.

In reference to Claim 7, in the case that the resilient film has, at its positions corresponding to the punches, narrower slits than a shape of each of the punches or a smaller through-pass hole than a shape of each of the punches, a force to be pushed and peeled off is restricted low as compared with the case in which the film is punctured with the punch, so that it has an effect that its fixing (attaching) against the bushing type die, the plate-like die and the stripper bushing or the like is stabilized.

In reference to Claim 8, since the slits and the through-pass holes are arranged such that the resilient film covers the lower releasing portions of the punch punctured holes, thereafter they are formed melting from above by the heating pins passing through the punch punctured holes, so that it is possible to arrange either the slits or through-pass holes for guiding the punches with a high position setting accuracy without attaining a precise position setting at a predetermined position of the resilient film pre-formed with the slits or through-pass holes.

In reference to Claim 9, since the resilient film arranged at the stripper bushing is constituted by a resilient flat plate-like film opposing against the inner surface top part of the stripper bushing and a non-resilient cylindrical spacer fitted to hold the resilient thin film with the inner surface top part of the stripper bushing in place of the film made of entirely resilient material and a fixed flange held by the stripper bushing and the support base is integrally formed at the lower end of the cylindrical spacer, only the resilient thin film can be replaced at the end of the durable years and then a less-expensive replacement cost is attained.

Having described specific preferred embodiments of the invention with reference to the accompanying drawings, it will be appreciated that the present invention is not limited to those precise embodiments, and that various changes and modifications can be effected therein by one of ordinary skill in the art without departing from the scope of the invention as defined by the appended claims.

## Claims

1. A die structure, wherein there is provided a resilient film 3 covering lower releasing portions of each of punch punctured holes of a die 1.

2. A die structure according to claim 1, wherein each of said punch punctured holes 21a is opened at a cylindrical bushing type die having a bottom section in which a nozzle port 21b for ejecting air toward extremity ends of punches while being communicated with an air supplying passage 41 which can be changed over in ON or OFF, the die is held by a die holder 11 and there is provided a resilient film 3 covering the lower releasing portions of the punch punctured holes 21a at an inner surface top portion higher than the nozzle port 21b.

3. A die structure according to claim 1, wherein each of said punch punctured holes 21a is opened directly closely near the plate-like die in place of one using a bushing type die.

4. A die structure according to claim 3, wherein said air supplying passage 41 which can be changed over in ON or OFF is formed at a support base 31 for supporting a plate-like die.

5. A die structure according to claim 2, wherein in place of said bushing type die, a stripper bushing 92 is replaced with it, fitted in said die holder 11 in an inverse state and used, and there is provided the resilient film 3 covering the lower releasing portions of the punch punctured holes 21a at at least the inner surface top part of said stripper bushing 92.

6. A die structure according to claim 5, wherein the resilient film 3 arranged at said stripper bushing 92 is of a hat-shape in which a cylindrical resilient portion with a bottom section fitted along the inner surface of the stripper bushing 92 and an annular spacer 23 cooperatively arranged at the lower end of the resilient portion and held by the stripper bushing 92 and the support base for a die holder 11 are provided integrally or separately.

7. A die structure according to any one of claims 2, 3 and 5, wherein said resilient film 3 has, at positions corresponding to its punches, narrower slits than a shape of the punch or smaller through-pass holes than a shape of the punch.

8. A die structure according to claim 7, wherein said slit and through-pass hole are opened through melting with a heating pin 100 inserted into and passed through the punch punctured hole 21a after the resilient film 3 is arranged to cover the lower releasing portion of the punch punctured hole 21a.

9. A die structure according to claim 5, wherein the resilient film 3 arranged at said stripper bushing 92 is comprised of a flat plate-like resilient thin film opposing against the inner surface top part of the stripper bushing 92 and a non-resilient cylindrical spacer 63 fitted to hold the resilient thin film with the inner surface top part of the stripper bushing 92 in place of a resilient film entirely formed of resilient member, said cylindrical spacer 63 has a fixed flange 63a held and supported at its lower end by a stripper bushing 92 and the support base 31 for the die holder 11.
